# EUROPEAN PATENT APPLICATION

(11) **EP 1 923 371 A1**
(43) Date of publication of application: **21.05.2008**
(21) Application number: 06799647.0
(22) Date of filing: 16.08.2006
(51) Int. Cl.: C04B 35/453, C04B 41/87, H01L 41/187

(54) **CERAMIC TARGET, FILM CONSTITUTING ZINC, GALLIUM AND BORON OXIDE AND METHOD OF MANUFACTURING OF THE SAID FILM**

(30) Priority: 16.08.2005 WO PCT/RU2005/000421
(71) Applicant: Otkrytoe Aktsyonernoe Obshchestvo "Polema", Tula 300016 (RU)
(72) Inventor: ABDUEV, Aslan Khajimuratovich, Moscow, 109341 (RU); ASVAROV, Abil Shamsudinovich, Makhachkala, 367000 (RU); AKHMEDOV, Akhmed Kadievich, Makhachkala, 367000 (RU); KAMILOV, Ibragimkhan Kamilovich, Makhachkala, 367000 (RU)
(74) Representative: HOFFMANN EITLE
(86) International application number: PCT/RU2006/000433
(87) International publication number: WO 2007/021221

(57) **Abstract**

The present invention relates to the field of opto-electronic technology and is intended to create transparent conductive layers. More concretely, the invention relates to the field of production of ceramic materials and is intended for using in manufacturing the ceramic targets, which serve as a source of material for magnetron, electron-beam, ion-beam and other films application methods in micro-, opto-, nanoelectronics, as well as to films produced from such a ceramic target and to a method for preparing such films. Disclosed is a ceramic target on the basis of zinc oxide doped with gallium containing from 0.5 to 6 atomic % of gallium and from 0.1 to 2 atomic % of boron, a portion of gallium and boron being contained in zinc oxide crystallites as a substitution admixture, and the rest portion of gallium and boron being contained together with zinc in the amorphous intergranular phase. Also proposed is a polycrystalline film on the basis of zinc oxide with the preferred orientation (001) doped with gallium in the structure of which from 0.1 to 2 % of zinc atoms are substituted by atoms of boron and from 0.5 to 6 % of zinc atoms are substituted by atoms of gallium, as well as a method for preparing thereof.

## Description

### FIELD OF THE INVENTION

The present invention relates to an optoelectronic technology area and is intended for creating transparent conductive layers.

More concretely, the invention relates to the production of ceramic materials and is intended for manufacturing ceramic targets, which present a source of material for magnetron, electron-beam, ion-beam and other methods for sputtering films in micro-, opto-, nanoelectronics, to films produced from such ceramic targets, and to a method for the formation of such films.

### DESCRIPTION OF THE PRIOR ART

Ceramic targets and methods for synthesis thereof consisting in that a mixture of components is prepared, compacted and sintered are known [J.M. Tairov, V.F.Tsvetkov. "Technology of semi-conducting and dielectric materials", Moscow, "Higher School" Publishing House, 1990, 423 pages].

Ceramic targets for magnetron sputtering are known.

The closest prior art for the ceramic target according to the invention and the method for preparing thereof is US Patent 5458753, published on October 17, 1995, in which the ceramic target consisting of zinc oxide and gallium is disclosed.

The disadvantage of the target according to the prototype is an insufficient density of the ceramics. This leads to a non-uniform sputtering of the material thereof during the film formation, generating macro particles on the target surface during sputtering, contaminating the surface of growth by clusters and non-uniform doping of the synthesized film

Another subject of the invention is a transparent conductive film, formed as the result of said ceramic target sputtering.

Transparent conductive films based on zinc oxide are known [W.W. Wang, X.G. Dio, Z. Wang, M. Yang, T.M. Wang Z. Wu. Preparation and characterization of high-performance direct current magnetron sputtered ZnO:Al films. Thin Solid Films 491 (2005) 54-60].

The disadvantage of these films is the absence of a doping admixture, as the result of which the zinc oxide films have an insufficient conductivity.

Transparent conductive films based on zinc oxide doped with gallium are known [P.K. Song, Watanabe, M. Kon, A. Mitsui, Y. Shigesato. "Electrical and optical properties of gallium-doped zinc oxide films deposited by DC magnetron sputtering. Thin Solid Films 411 (2002) 82-86].

The disadvantage of these films is a reducing of the carrier mobility and chemical resistance.

The closest prior art of the present invention is a film on the basis of zinc oxide doped with gallium. The ionic radius of gallium is close to that of zinc therefore it makes it possible to incorporate gallium in the zinc oxide in substantial concentrations [US 5,458,753, 17.10.1995].

The disadvantage of these films is the presence of columnar structure, what leads to deterioration of characteristics thereof, in particular, to film property anisotropy.

One more object of the invention is a method for synthesizing the above transparent conductive films.

Many synthesis methods of zinc oxide films (gas-transport, pyrolitic and others) are known. The closest prior art is a synthesis method of film based on zinc oxide consisting in that, on the surface of growth by a method of magnetron sputtering of the ceramic target, the main material, zinc oxide and a doping admixture, gallium, are applied [P.K. Song, Watanabe, M. Kon, A. Mitsui, Y. Shigesato. "Electrical and optical properties of gallium-doped zinc oxide films deposited by DC magnetron sputtering. Thin Solid Films 411 (2002) 82-86].

The disadvantage of the synthesis method according to the prototype is the imperfection of formed films, namely: occurrence and further conservation the film columnar structure deteriorating film properties as described in the above.

### SUMMARY OF THE INVENTION

The purpose of the present invention consists in qualitative improving the characteristics of the transparent conductive films based on zinc oxide and doped with gallium by increasing their structural perfection, which depends on the process occurring on the surface of growth. For preparing such a film it is necessary to have the corresponding ceramic material having a high density and the structure, which prevents non-uniformity of sputtering and formation of macrostructures on the surface of ceramics during sputtering.

The indicated purpose is attained in that the ceramic target is proposed in the composition of which boron is included, together with zinc oxide and gallium.

In particular, together with zinc oxide, the target according to the invention contains from 0.5 to 6 at. % of gallium and from 0.1 to 2 at. % of boron. At the same time, the doping admixtures are contained as a substituting admixture both in the zinc oxide crystal lattice and in the grain boundaries in the form of an amorphous phase containing in its composition zinc, gallium, boron and oxygen in the composition thereof.

Another purpose of the present invention is to increase the carriers' mobility, to decrease a degradation of properties of the instruments including these films under the external action and to increase the cristallinity in the film lattice that makes the properties thereof predictable and calculable.

This purpose is attained by that a polycrystalline film based on zinc oxide doped with gallium is proposed in the composition of which boron is present.

One more purpose of the present invention is to increase a structural perfection by preventing, in particular, the formation of film columnar structure.

The indicated purpose is solved by that a method for synthesizing a film is proposed according to which on the film surface of growth, further to the main material (zinc oxide) and doping admixture (gallium), boron is also applied as a component increasing the mobility of atoms adsorbing on the surface of growth.

### DETAILED DESCRIPTION OF THE INVENTION

One subject matter of the invention is the ceramic target. It is prepared by grinding the mixture of zinc oxide powder, metal gallium and boron-containing substance, pressed and sintered at a temperature providing a liquid state of gallium before covering zinc oxide particles with a mixture of liquid gallium and a boron-containing substance. The quantitative composition of the components is defined by the composition of a ceramics.

The composition of the synthesized ceramics, along with zinc oxide, includes from 0.5 to 6 at. % of gallium and from 0.1 to 2 at. % of boron, the portion of gallium and boron being present in the crystal lattice of zinc oxide as a substituting admixture, and the rest portion of gallium and boron is contained, together with zinc oxide, in the form of an amorphous phase in the grain boundaries.

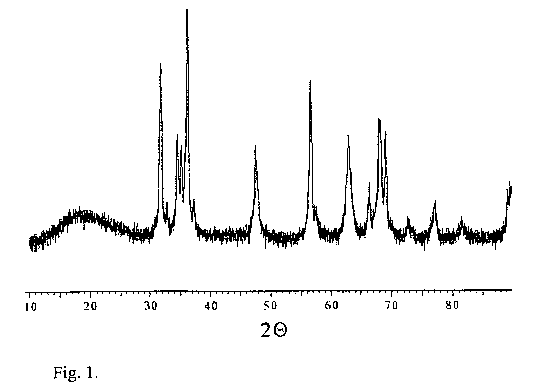

On Fig. 1 a diffraction pattern of the ceramic target ZnO:Ga:B is shown. From this diffraction pattern it is possible to see a structureless band corresponding to the amorphous phase presenting at the grain boundaries.

Grinding the zinc oxide powder with a liquid metal gallium [RU 2004105169] leads to covering zinc oxide particles at all round with a layer of gallium, that is difficult to achieve in another way (for example, it is impossible to do so by sputtering). This provides uniformity of gallium distribution trough the volume of ceramics and, consequently, trough the volume of a film sputtering from this ceramics. The following grinding with a boron oxide or with a compound forming the boron oxide in the process of annealing (for example, a boric acid) leads to covering the zinc oxide particles with a boric acid particles (boric acid can be introduced in the form of an aqueous solution, ground and dried a little or pressed directly). Boron oxide formed in the ceramics at heating dissolves a gallium oxide formed from gallium and then zinc oxide creating thereby a liquid surface phase on the particles during sintering. At heating, liquid gallium deteriorates materials more than any other liquid metal [Chemical Encyclopedia, "Sovetskaya Encyclopedia" Publishing House, Moscow, 1988, page 935], therefore, zinc oxide particles are also subject to the gallium deterioration and subsequent dissolving in the boron oxide, that also increases uniformity of the ceramics.

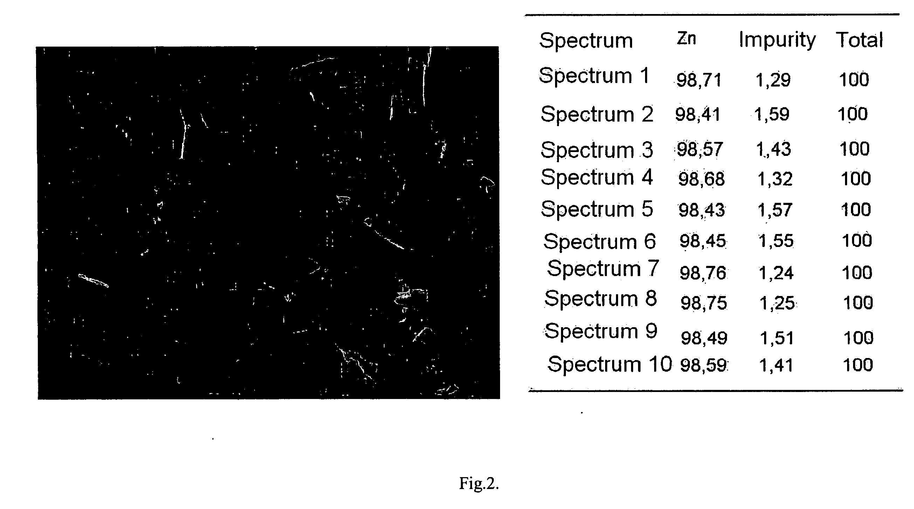

Fig. 2 presenting the element analysis data according to characteristic X-ray emission obtained with a scanning electron microscope (SEM), type LEO 1450, illustrates the evenness of the obtained ceramics.

Thus, grinding zinc oxide powder with gallium increases the uniformity of distribution thereof trough the volume of ceramics and film, and the addition of boron results in that boron, due to the interaction of oxide thereof with gallium oxide at a high temperature and with zinc oxide particles deteriorated by gallium, increases the uniformity of distribution of the admixture within the volume. In the absence of gallium, boron oxide is not distributed so evenly and, vice versa, in the absence of boron the uniformity of distribution of gallium decreases, in both cases it is impossible to obtain those film parameters, which are obtainable when gallium and boron are present simultaneously. On the one hand, in the ceramics gallium is irreplaceable, since it is necessary for the film growing therefrom and since the physical properties of gallium permit to spread it on the surface of the zinc oxide particles by the described method thus increasing the uniformity of distribution of gallium trough the volume of ceramics and film. Gallium deteriorates also zinc oxide particles with the same effect. On the other hand, during the ceramics sintering boron oxide dissolves gallium oxide and zinc oxide creating thereby a liquid phase at the boundaries of particles and in places of deterioration of zinc oxide particles created by gallium. Due to this fact the density and conductivity of ceramics increases, and much more increases the uniformity of distribution of admixtures.

Another subject matters of the invention are: a transparent polycrystalline film prepared from the ceramic target according to the invention and a method for synthesizing this film.

The film according to the invention comprises a polycrystalline film on the basis of zinc oxide with the preferred orientation (001) doped with gallium which additionally contains boron and in the structure of which from 0.1 to 2 % of zinc atoms are substituted by the atoms of boron and from 0.5 to 6 % of the zinc atoms are substituted by the atoms of gallium.

The sputtering of films is carried out on magnetron sputtering equipment (highfrequency or DC current installations). As a target used is the target according to the invention. The films are applied on substrates, in particular, on glass. The sputtering is carried out in the atmosphere of argon at a substrate temperature from room to 350°C.

The presence of boron in the film is important because during sputtering boron increases the mobility of adsorbing atoms on the surface of the growing film that substantially increases the structural perfection of the film and characteristics thereof (optical, electrical, and stability). At the same time, for example, the usually occurring columnar structure of films does not occur, the conductivity is increased and etc. (there are electronic photos and other confirming materials). Boron, fulfilling this function, remains in the zinc oxide lattice substituting the zinc therein and creating a donor centre, similarly to gallium (these are elements of the same group), i.e. boron does not contaminate the film and does not affect negatively to other properties thereof. It is not possible to use boron only as the admixture, since its ionic radius is substantially less than the ionic radius of zinc and when boron substitutes zinc the lattice strains occur that are not permissible in the large concentrations. The necessity to introduce gallium is connected with that the ionic radius thereof is close to the ionic radius of zinc and the substitution does not result any substantial strains in the lattice; therefore, gallium can be introduced in the concentrations, which are sufficient for the required conductivity.

On the other hand gallium is also irreplaceable in the film, since its ionic radius is close to the ionic radius of zinc, that allows its introducing in the required amounts for the necessary conductivity without increasing substantially the strains in the lattice.

In the proposed film, as in the prototype, gallium substitutes zinc in the zinc oxide lattice and creates donor levels without introducing substantial lattice strains, and boron prevents the degradation of film properties and the formation of columnar structures. Boron also substitutes zinc in the zinc oxide lattice creating thereby a donor level, but the use thereof as a sole donor does not permit to obtain a high conductivity, since the ionic radius of boron essentially differs from the ionic radius of zinc, and at a high level of doping with boron the occurring lattice strains deteriorate its structure as well as electric and optical parameters.

Fig. 3 shows the electronic photography of a cross section of the film ZnO:Ga:B synthesized at the temperature of the substrate T = 200°C.

Fig. 4 shows the electronic photography of a cross section of the film ZnO:Ga synthesized at the temperature of substrate T = 200°C.

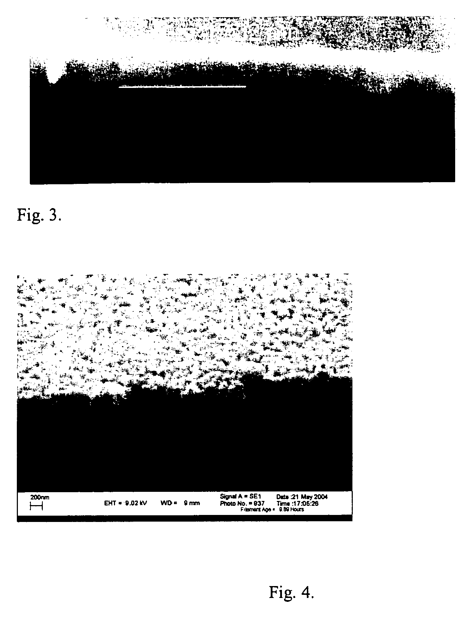

Comparing data of Fig. 3 and Fig. 4 it is possible to see that the ZnO:Ga:B layers do not demonstrate any noticeable relief of cleavage in contrast to the film of the prototype.

On Fig. 4 it is shown that ZnO:Ga layers have a typical columnar structure being the consequence of low mobility of reagents deposited on the surface in the process of synthesis. At the same time the layers have a developed surface that damages the optical and electrical characteristics.

The presence of the developed relief, as well as the grain boundaries (column boundaries), leads to increasing the etching rate, as well as to the selective etching of films that decreases thereby the chemical stability thereof.

In Table 1 it is shown that at the predetermined temperatures the specific resistances of layers are not substantially changed depending on the thickness thereof. This is the evidence of the absence of the substantive defective transition layer on the boundary film - substrate.

**Table 1**

| Specific resistances of ZnO:Ga:B layers of various thickness synthesized at various temperatures | | | |
|---|---|---|---|
| | 50 nm (Ω.cm) | 100 nm (Ω.cm) | 150nm Ω.cm) |
| 25°C | 3 x 10⁻³ | 2.5 x 10⁻³ | 1.2 x 10⁻³ |
| 120°C | 1.08 x 10⁻³ | 1.00 x 10⁻³ | 7.8 x 10⁻⁴ |
| 200°C | 4.50 x 10⁻⁴ | 4.50 x 10⁻⁴ | 4.50 x 10⁻⁴ |

It is possible to see from Table 2 that the layers of ZnO:Ga:B do not change substantially the electric characteristics thereof in the processes of thermal treatments at temperatures about 200°C.

**Table 2**

| Comparative values of the specific resistances of ZnO:Ga and ZnO:Ga:B layers after the synthesis, as well as after the treatments of films in vacuum and in the open atmosphere at the temperature of 200°C for 1 hour | | | | |
|---|---|---|---|---|
| | ZnO:Ga 25°C 150 nm | ZnO:Ga 200°C 150 nm | ZnO:Ga:B 25°C 150 nm | ZnO:Ga:B 200°C 150 nm |
| ρ (Ω x cm) | 1.2 x 10⁻³ | 4.5 x 10⁻⁴ | 6.75 x 10⁻⁴ | 3.0 x 10⁻⁴ |
| ρ_{vacuum} (Ω x cm) | 1 x 10⁻³ | 4.0 x 10⁻⁴ | 4.50 x 10⁻⁴ | 4.50 x 10⁻⁴ |
| ρₐᵢᵣ (Ω x cm) | 8.4 x 10⁻³ | 6.0 x 10⁻⁴ | 1.13 x 10⁻³ | 3.3 x 10⁻⁴ |

Table 3 shows the comparative values of the etching rates of ZnO:Ga and ZnO:Ga:B layers in 0.1M solution of oxalic acid.

**Table 3**

| Comparative values of the etching rates of ZnO:Ga and ZnO:Ga:B layers in 0.1 M solution of oxalic acid | | |
|---|---|---|
| | ZnO:Ga | ZnO:Ga:B |
| Tᵣₒₒₘ | 5 nm/sec | 4 nm/sec |
| 200°C | 2 nm/sec | 1.5 nm/sec |

Thus, the authors have found out for the first time that the presence of boron increases the migration rate of the atoms adsorbing on the zinc oxide surface that leads to the uniform distribution of the atoms on this surface and prevents the formation of columnar structures, i.e. increases the crystal perfection and, as a consequence, increases the carriers mobility and conductivity. Such a solution of the claimed problem is not obvious for those skilled in the art.

The obtaining of zinc oxide ceramics with gallium and boron contains an idea of the mutual strengthening the uniformity by boron and gallium and distribution thereof trough the volume of ceramics: gallium deteriorates the particles of the zinc oxide powder along their defects and non-uniformities, while the boron oxide develops this deterioration, dissolving both gallium oxide and zinc oxide. The fact that gallium with boron do not practically interact chemically with each other (not to be confused with oxides) and do not form clusters during sputtering keeping on the surface of growth has been also used. Both these circumstances are not obvious at all to those skilled in the art before reading the present invention.

The invention will be further illustrated by examples, which serve for illustration only the essence of the invention and do not have a limiting character.

### DESCRIPTION OF THE PREFERRED EMBODIMENTS OF THE INVENTION

An Example of an embodiment of the proposed target is the target prepared from zinc oxide doped with gallium. 100 g of ZnO powder were taken, 2.7 g of metal gallium (about 3 at. %) were introduced therein and the mixture was thoroughly triturated in a ceramic dish till complete gallium transferring on the surface of the zinc oxide particles. After grinding an aqueous solution of boric acid in the amount of 0.8 g (about 1 at. %) is introduced into the prepared mass. The mixture is triturated and dried in a drying chamber, pressed at the pressure of 1000 kg/cm² and sintered during 10 hours at the temperature of 1200°C.

The density of the synthesized ceramics is 5.65 g/cm³, that constitutes 99% of theoretical density thereof.

An Example of a particular embodiment of the proposed invention is a zinc oxide polycrystalline film of the orientation (001) doped with gallium (3 at. %) and boron (1 at. %), which was synthesized by the magnetron sputtering from the ceramic target on the basis of zinc oxide with the oxides of gallium (3 %at.) and boron (1 %at.). The ceramic target is synthesized by the triturating of the powder of zinc oxide, gallium or gallium oxide and the boric acid solution at the temperature of 30°C, pressing at the pressure of 1000 kg/cm² and sintered during 10 hours at the temperature of 1200°C.

The density of the synthesized ceramics is 5.63 g/cm³ that constitutes about 99% of theoretical density thereof.

## Claims

1. A ceramic target based on zinc oxide doped with gallium, which contains from 0.5 to 6 atomic % of gallium and from 0.1 to 2 atomic % of boron, a portion of gallium and boron being contained in zinc oxide crystallites as a substitution admixture, and the rest portion of gallium and boron being contained together with zinc in the amorphous grain boundary phase.

2. A polycrystalline film on the basis of zinc oxide with the preferred orientation (001) doped with gallium, which contains boron, and in the structure thereof from 0.1 to 2 % of zinc atoms are substituted by atoms of boron and from 0.5 to 6 % of zinc atoms are substituted by atoms of gallium.

3. A method of synthesis of a polycrystalline film consisting in that the film is applied by a method of magnetron sputtering of the ceramic target according to claim 1.
